Europäisches Patentamt

European Patent Office

Office européen des brevets

(19)

(11) Veröffentlichungsnummer: **0 331 135**

**A2**

(12) EUROPÄISCHE PATENTANMELDUNG

(21) Anmeldenummer: 89103555.2

(22) Anmeldetag: 01.03.89

(51) Int. Cl.⁴: **G01R 33/06 , //G06K7/08**

(30) Priorität: 03.03.88 DE 3806808

(43) Veröffentlichungstag der Anmeldung:
06.09.89 Patentblatt 89/36

(84) Benannte Vertragsstaaten:
**BE DE FR GB SE**

(71) Anmelder: **Standard Elektrik Lorenz
Aktiengesellschaft
Lorenzstrasse 10
D-7000 Stuttgart 40(DE)**

(84) **DE**

Anmelder: **ALCATEL N.V.
Strawinskylaan 537 (World Trade Center)
NL-1077 XX Amsterdam(NL)**

(84) **BE FR GB SE**

(72) Erfinder: **Becker, Helmut, Dr.
Norikerstrsse 19
D-8500 Nürnberg(DE)**
Erfinder: **Kiessling, Armin Gottfried
Westring 12
D-8501 Rosstal(DE)**

(74) Vertreter: **Graf, Georg Hugo, Dipl.-Ing. et al
Standard Elektrik Lorenz AG Patent- und
Lizenzwesen Postfach 30 09 29
D-7000 Stuttgart 30(DE)**

(54) Vorrichtung zur Feststellung von magnetisierten Bereichen.

(57) Ein magnetisches Feld kann dadurch festgestellt werden, daß magnetisierte Bereiche an einem magnetfeldabhängigen Widerstand vorbeibewegt werden. Auf das sich dabei ändernde Magnetfeld spricht der magnetfeldabhängige Widerstand an. Die einwandfreie Detektion von Magnetfeldern ist durch die Breite der verwendeten streifenförmigen magnetfeldabhängigen Widerstände begrenzt.

Zur Optimierung der Empfindlichkeit sind zwischen dem magnetfeldabhängigen Widerstand und den magnetisierten Bereichen zwei voneinander beabstandete ferromagnetische Polstücke (6, 7) in der Weise angeordnet, daß die Enden (8, 9) der Polstücke am magnetfeldabhängigen Widerstand (4) einen ersten Spalt (10) mit einer Breite (11) in der Größenordnung der Breite (12) des magnetfeldabhängigen Widerstandes (4) und die Enden (13, 14) an den magnetisierten Bereichen einen zweiten, wesentlich schmaleren Spalt (16) bilden.

Fig. 1

## Vorrichtung zur Feststellung von magnetisierten Bereichen.

Die Erfindung bezieht sich auf eine Vorrichtung gemäß dem Oberbegriff des Anspruchs 1.

Derartige Magnetfelddetektoren und Sensoren für Magnetfelddetektoren sind aus der Druckschrift "Magnetoresistive Sensoren" (TI 840323) der Fa. Volvo bekannt. Bei den bekannten Vorrichtungen wird das Vorhandensein eines magnetisierten Bereiches dadurch festgestellt, daß das magnetische Feld eines magnetisierten Bereiches auf einen magnetfeldabhängigen Widerstand einwirkt, dessen daraus resultierende Widerstandsänderung angezeigt oder zur Regelung oder Steuerung benutzt wird. Die Empfindlichkeit des magnetfeldabhängigen Widerstandes ist von der Geometrie des magnetfeldabhängigen Widerstandes und des magnetisierten Bereiches abhängig.

Der Erfindung liegt das technische Problem zugrunde, eine Vorrichtung zur Feststellung von magnetischen Bereichen zu schaffen, welche derart gestaltet ist, daß die Empfindlichkeit des magnetfeldabhängigen Widerstandes unabhängig von der Geometrie des magnetisierten Bereiches stets optimal ist.

Gelöst ist dieses Problem durch die im Kennzeichen des Anspruchs 1 angegebenen Merkmale. Bei der erfindungsgemäßen Lösung können alle Bestandteile der Vorrichtung nämlich der magnetfeldabhängige Widerstand, Lage und Größe des von den Polstücken gebildeten Spaltes nahe dem magnetfeldabhängigen Widerstand sowie Lage und Größe des Spaltes am magnetischen Bereich unabhängig voneinander optimiert werden.

Weitere vorteilhafte Ausgestaltungen der Erfindung sind in den Ansprüchen 2 bis 8 angegeben und nachfolgend anhand eines in den Zeichnungen veranschaulichten Ausführungsbeispieles beschrieben. Es zeigen:

Fig. 1 die Draufsicht auf ein Ausführungsbeispiel des erfindungsgemäßen Magnetfelddetektors.

Fig. 2 die Ansicht der unteren Stirnseite des Magnetfelddetektors und

Fig. 3 die Ansicht des Magnetfelddetektors am Schnitt A-A der Fig. 1.

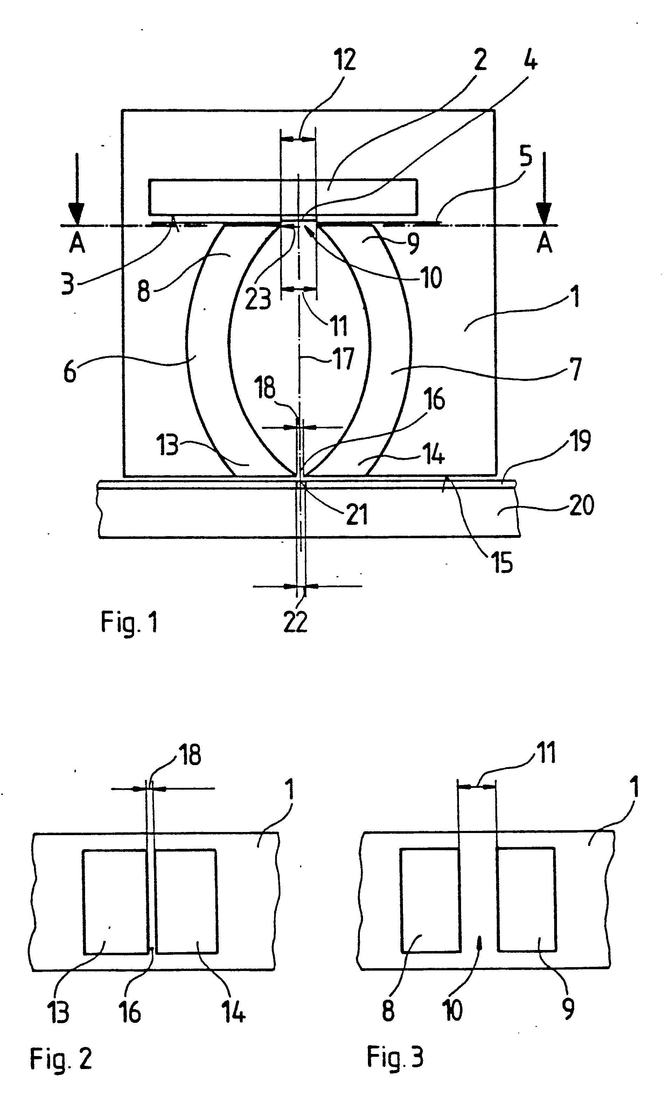

Wie in Fig. 1 zu erkennen ist, befindet sich in dem Isolierblock 1, beispielsweise aus Kunstharz, der isolierende plattenförmige Träger 2 aus Glas, Keramik oder Kunststoff, auf dessen - in Fig. 1 unterer - Fläche 3 der magnetfeldabhängige Widerstand 4 in Streifenform angeordnet ist. Die Streifen des magnetfeldabhängig Widerstandes sollen senkrecht in die Papierebene hinein verlaufen. Die Feldlinien des auf den magnetfeldabhängigen Widerstand einwirkenden Magnetfeldes verlaufen im Spalt 10 zwischen den Enden der Polstücke 6, 7.

Der magnetfeldabhängige Widerstand 4 oder die gesamte Oberfläche 3 des Trägers 2 ist mit einer Isolierfolie 5 abgedeckt, deren Stärke 10 bis 50μm, vorzugsweise 20 bis 30μm betragen sollte.

An der Oberfläche 3 sind neben dem magnetfeldabhängigen Widerstand 4 zwei Polstücke 6 und 7 aus einem ferromagnetischen Werkstoff angeordnet, deren Enden 8 und 9 planparallel zur Oberfläche 3 geschliffen sind. Durch den Abstand zwischen den Enden 8, 9 entsteht der erste Spalt 10. Dessen Breite 11 liegt in der Größenordnung der Breite 12 des magnetfeldabhängigen Widerstandes 4. Bevorzugte Breiten liegen zwischen 50 und 300μm, insbesondere bei etwa 150μm. Die Ausbildung des Spaltes 10 ist aus Fig. 3 ersichtlich.

Die Polstücke 6,7 sind derart bogenförmig ausgebildet, daß sich die vom Träger 2 abgewandten Enden 13 und 14 der Polstücke 6, 7 an der Frontseite 15 des Isolierblockes 1 wieder einander annähern. Dort bilden sie einen zweiten Spalt 16. Durch die bogenförmige Gestalt der Polstücke 6, 7 ist deren Abstand außer im Bereich der Spalte 10 und 16 ein Vielfaches der Breite 11 bzw. 18 der Spalte 10 und 16. Deshalb wird ein magnetisches Streufeld zwischen den Polstücken 6, 7 weitgehend vermieden. Die Enden 13, 14 an der Frontseite 15 sollten plangeschliffen ausgebildet sein. Die Oberfläche der Enden 13, 14 kann aber auch von dieser Planheit abweichen. Das gleiche gilt für die Enden 8 und 9. Die Fronseite 15 sollte zur Oberfläche 3 des Trägers 2 planparallel angeordnet sein.

Die Breite 18 des zweiten Spaltes 16 ist wesentlich kleiner als die Breite 11 des ersten Spaltes 10. Die Breite des Spaltes 16 beträgt etwa 1 bis 100μm, vorzugsweise 40 bis 50μm. Die Ausbildung des Spaltes 16 ist aus der Fig. 2 ersichtlich.

Beim Einsatz des Magnetfelddetektors wird an der Frontseite 15 beispielsweise ein mit einem magnetisierten Bereich 19 versehener nicht ferromagnetischer Träger 20 vorbeibewegt. Der nicht ferromagnetische Träger kann eine Vielzahl von magnetisierten Bereichen 19 enthalten, deren Breite 22 so gering wie die Breite 18 des zweiten Spaltes 16 sein kann. Selbst bei derart geringen Abmessungen der magnetisierten Bereiche 19 ist am ersten Spalt 10 noch ein ausreichend starkes Magnetfeld 23 vorhanden, welches den elektrischen Widerstand des magnetfeldabhängigen Widerstandes 4 zu verändern in der Lage ist. Mit einer elektronischen Schaltung kann aus der Widerstandsänderung ein Signal erzeugt werden, das zu Anzeige-, Regel- und Steuerzwecken verwendbar ist.

Bei den magnetisierten Bereichen kann es sich um einen auf einer Karte aus nicht ferromagnetischem Werkstoff angeordneten Strichcode aus einem permanent magnetischen Werkstoff handeln. Die magnetisierten Bereiche können aber auch auf einem Rad angeordnet sein.

## Ansprüche

1. Vorrichtung zur Feststellung von magnetisierten Bereichen eines Gegenstandes, welche einen streifenförmigen magnetfeldabhängigen Widerstand enthält, **dadurch gekennzeichnet,** daß zwischen dem Ort des magnetfeldabhängigen Widerstandes und dem Ort des magnetischen Bereiches mit Abstand voneinander zwei Polstücke (6, 7) aus einem ferromagnetischen Werkstoff derart angeordnet sind, daß sie an ihren dem magnetfeldabhängigen Widerstand (4) zugewandten Enden (8, 9) einen ersten Spalt (10) bilden, dessen Breite (11) etwa der Breite (12) des magnetfeldabhängigen Widerstandes (4) entspricht, und an ihren vom magnetfeldabhängigen Widerstand (4) abgewandten Enden (13, 14) einen zweiten Spalt (16) bilden, dessen Breite (18) in der Größenordnung eines magnetisierten Bereiches (21) liegt, und daß der Abstand der Polstücke (6, 7) außerhalb der Spalte (10, 16) sehr viel größer als an den Spalten ist.

2. Vorrichtung nach Anspruch 1, dadurch gekennzeichnet, daß die Polstücke (6, 7) einen nach außen gebogenen Verlauf aufweisen.

3. Vorrichtung nach Anspruch 1 oder 2, dadurch gekennzeichnet, daß die Polstücke (6, 7) schräg zu den Spalten (10, 16) hin verlaufend angeordnet sind und die Enden (8, 9; 13, 14) der Polstücke (6, 7) in der senkrecht zur Verbindungslinie (17) der beiden Spalte (10, 16) verlaufende Ebene plangeschliffen sind.

4. Vorrichtung nach einem der Ansprüche 1 bis 3, dadurch gekennzeichnet, daß der magnetfeldabhängige Widerstand (4) und sein Träger (2) sowie die Polstücke (6, 7) in einem Kunststoffblock (1) eingeformt sind, der an den, den magnetisierten Bereichen zugewandten Enden (13, 14) der Polstücke (6, 7) plangeschliffen ist.

5. Vorrichtung nach einem der Ansprüche 1 bis 4, dadurch gekennzeichnet, daß die Breite (18) des Spaltes (16) nahe dem magnetisierten Bereich 1 bis 100μm, insbesondere 50μm beträgt.

6. Vorrichtung nach einem der Ansprüche 1 bis 5, dadurch gekennzeichnet, daß die Breite (11) des Spaltes (10) am magnetfeldabhängigen Widerstand (4) 50 bis 300μm, insbesondere 150μm, beträgt.

7. Vorrichtung nach einem der Ansprüche 1 bis 6, dadurch gekennzeichnet, daß die Polstücke (6, 7) vom magnetfeldabhängigen Widerstand (4) durch eine Isolierfolie (5) getrennt sind.

8. Vorrichtung nach Anspruch 7, dadurch gekennzeichnet, daß die Isolierfolie (5) eine Dicke von 10 bis 50μm, insbesondere 20 bis 30μm, besitzt.

Fig. 1

Fig. 2

Fig. 3